# EUROPÄISCHE PATENTANMELDUNG

(11) **EP 0 669 653 A1**
(43) Veröffentlichungstag der Anmeldung: **30.08.1995**
(21) Anmeldenummer: 95200193.1
(22) Anmeldetag: 27.01.1995
(51) Int. Cl.: H01L 25/11, H01L 23/52

(54) **Leistungshalbleitermodul sowie Schaltungsanordnung mit mindestens zwei Leistungshalbleitermoduln**

(30) Priorität: 21.02.1994 DE 4405443
(71) Anmelder: ABB Management AG, CH-5401 Baden (CH)
(72) Erfinder: Stockmeier, Thomas, Dr., CH-5404 Baden (CH); Thiemann, Uwe, Dr., Rancho Palos Verdes, CA 90275 (US)
(74) Vertreter: Lück, Gert, Dr.

(57) **Zusammenfassung**

Es wird eine Schaltungsanordnung und ein Leistungshalbleitermodul angegeben, wobei die Schaltungsanordnung mehrere parallelgeschaltete Leistungshalbleitermodule umfasst, von denen nur eines mit einer Steuervorrichtung verbunden ist. Die übrigen Module arbeiten als Slaves des mit der Steuervorrichtung verbundenen Masters und beziehen die zur Ansteuerung benötigten Signal über einen Signal-Bus vom Master. Zu diesem Zweck weisen die Leistungshalbleitermodule eine Anzahl von Signalanschlüssen auf, welche untereinander verbunden sind. Die Signalanschlüsse können mit den Steueranschlüssen z.B. via eine Schnittstelle signalmässig verbunden werden. Mit den erfindungsgemässen Leistungshalbleitermodulen erhält man eine Schaltungsanordnung, in welcher mehrere Module bis höchsten Leistungen ohne Einschränkungen parallelgeschaltet werden können.

## Beschreibung

### Technisches Gebiet

Die Erfindung bezieht sich auf das Gebiet der Leistungselektronik.

Sie geht aus von einer Schaltungsanordnung bzw. von einem Leistungshalbleitermodul nach dem Oberbegriff der entsprechenden unabhängigen Ansprüche.

### Stand der Technik

Die Europäische Patentanmeldung EP-A2-0 417 747 beschreibt bereits eine solche Schaltungsanordnung bzw. ein solches Leistungshalbleitermodul.

Die Schaltungsanordnung umfasst dabei mindestens zwei Leistungshalbleiterschaltermodule mit einem Gehäuse, zwei Hauptanschlüssen und zwei Steueranschlüssen. Dementsprechend sind die eingesetzten Leistungshalbleitermodule aufgebaut.

Ein Modul umfasst in der Regel mehrere Halbleiterbauelemente, die zu einer logischen Funktionseinheit zusammengefasst werden können. Beispiele sind Gleichrichter, Einzelschalter mit antiparalleler Diode oder ganze Phasenbausteine. Solche Module (Thyristor-, Transistor-, IGBT-, Dioden-Module) sind heute im Leistungsbereich von 1200V und einigen 100A weit verbreitet und werden vor allem in Industrieantrieben eingesetzt.

Um eine geforderte Leistungsfähigkeit zu erhalten, werden in der Regel mehrere Bauelemente eines Typs in einem Modul parallelgeschaltet. So kann z.B. ein IGBT-Halbbrücken-Modul für 150A, 1200V je sechs parallelgeschaltete IGBTs und je zwei parallelgeschaltete antiparallel Dioden pro Schaltfunktion enthalten.

Gegenwärtig sind der Leistungsfähigkeit der Module - insbesondere betr. Stromtragfähigkeit - nach oben Grenzen gesetzt, da man Module nicht beliebig gross bauen kann. Die Schwierigkeiten liegen in den mit der Baugrösse stark zunehmenden Zuverlässigkeitsproblemen und der sich immer schwieriger gestaltenden Parallelschaltung einer grossen Zahl von Bauelementen.

Zudem verliert man mit zunehmender Grösse der Module eine ihrer hervorragende Eigenschaften, nämlich die Modularität, d.h. die Erhöhung der elektrischen Leistung nicht durch immer grössere Komponenten, sondern durch Parallelisierung von immer mehr gleichartigen Komponenten. Aus diesen Gründen wäre die unbeschränkte Parallelschaltbarkeit von Modulen eine erwünschte Eigenschaft.

Leider sind der Parallelschaltbarkeit von Modulen Grenzen gesetzt. Da nämlich die elektrischen Parameter der Module nie ganz identisch sind, kann das Durchlass-, Sperr- und Schaltverhalten der Module verschieden sein. Dies kann bei der Parallelschaltung zu Schwingungen oder Überlastung einzelner Module bis zu deren Zerstörung führen. Dem versucht die eingangs genannte Schrift entgegenzuwirken, indem sie die Induktivität des Kommutierungskreises durch eine spezielle Anordnung der Elektroden zu verkleinern versucht.

Damit werden aber die oben genannten Probleme, die durch Parameterunterschiede hervorgerufen werden, nicht berücksichtigt. Dieses Problem wird in der Regel so gelöst, dass die parallelzuschaltenden Module im Hinblick auf kritische Parameter vorselektiert werden. Dadurch wird es in der Anwendung später praktisch unmöglich, ein einzelnes Modul einer Parallelschaltung zu ersetzen. Eine weitere Möglichkeit besteht darin, dass die Module nicht bis zu ihrer spezifizierten Leistungsfähigkeit ausgenützt werden ("Derating").

Bei einer neuen Klasse von Modulen, den sogenannten integrierten oder intelligenten Modulen (Integrated Power Module, IPM) sind zusätzliche Funktionen wie Ansteuerung der schaltenden Bauelemente, Logik zur Erkennung von Fehlern (z.B. Übertemperatur, Überstrom, Unterspannung der Speisung) sowie elektrische Isolation der Ansteuer- und Fehlersignale in das Modul eingebaut.

Bei der für hohe Leistungen notwendigen Parallelschaltung solcher Module kommen deshalb zu den oben geschilderten Problemen noch die der nicht exakt gleichzeitig arbeitenden Ansteuerung, Fehlererkennung und -bearbeitung etc. hinzu.

So kann es z.B. durch eine geringfügige Schwankung der Spannungsversorgung des Empfängers eines Lichtleiters, der zur potentialfreien Übertragung des Triggersignals eingesetzt wird und der in das Modul integriert ist, zu einer Laufzeitverzögerung von einigen 100nsec kommen, was die Parallelschaltung solcher Module erheblich beeinträchtigt.

### Darstellung der Erfindung

Aufgabe der vorliegenden Erfindung ist es, eine Schaltungsanordnung und ein Leistungshalbleitermodul anzugeben, bei welchen die o.g. Probleme bei der Parallelschaltung vermieden werden können. Insbesondere soll das Leistungshalbleitermodul ohne Vorselektion und Derating bis zur vollen spezifizierten Leistungsfähigkeit mit anderen Modulen parallelgeschaltet werden können.

Diese Aufgabe wird bei einer Schaltungsanordnung bzw. einem Modul der eingangs genannten Art durch die Merkmale des entsprechenden unabhängigen Anspruchs gelöst.

Kern der Erfindung ist es also, dass das Leistungshalbleitermodul neben dem Steueranschluss und den Hauptanschlüssen eine Anzahl Signalanschlüsse aufweist, welche bei der Parallelschaltung von mehrere Modulen untereinander verbunden werden. Zudem ist nur ein einziges, frei wählbares Leistungshalbleitermodul mit der Steuervorrichtung verbunden.

Damit ergibt sich bei der Parallelschaltung von mehreren, erfindungsgemässen Modulen ein gemeinsamer Signalbus, welcher von demjenigen Modul getrieben wird, welches mit der Steuervorrichtung in Verbindung steht. Dieses Modul arbeitet also als Master während die übrigen die Funktion eines Slaves haben.

Bevorzugterweise wird die Verbindung zwischen den Steueranschlüssen und der Steuervorrichtung potentialfrei und insbesondere mit Lichtwellenleitern hergestellt. Zudem können die Module auf einen Kühlkörper montiert sein.

Zwischen den Steueranschlüssen und den Signalanschlüssen kann zudem eine Schnittstelle vorgesehen werden, welche die notwendigen Signalanpassung vornimmt. Diese Schnittstelle kann entweder nur beim Master oder bei allen parallelgeschalteten Modulen realisiert sein.

Weitere Ausführungsbeispiele ergeben sich aus den entsprechenden Unteransprüchen.

Der Vorteil des erfindungsgemässen Aufbaus besteht insbesondere darin, dass mehrere erfindungsgemässe Module ohne Vorselektion oder Derating parallelgeschaltet werden können, denn der Master diktiert die übrigen Module, so dass die eingangs genannten Probleme wegfallen. Zudem muss nur ein Typ von Modulen gefertigt werden und nur eine potentialfreie Verbindung zur Verfügung gestellt werden. Dadurch reduzieren sich die Herstellungskosten für den Anwender erheblich. Aber auch die Betriebskosten können wirksam gesenkt werden, denn erstens wird durch die gleichmässige, vom Master diktierte Belastung aller Module die Lebensdauer erhöht und zweitens kann ein defektes Module problemlos innerhalb der Parallelschaltung ausgewechselt werden.

### Kurze Beschreibung der Zeichnung

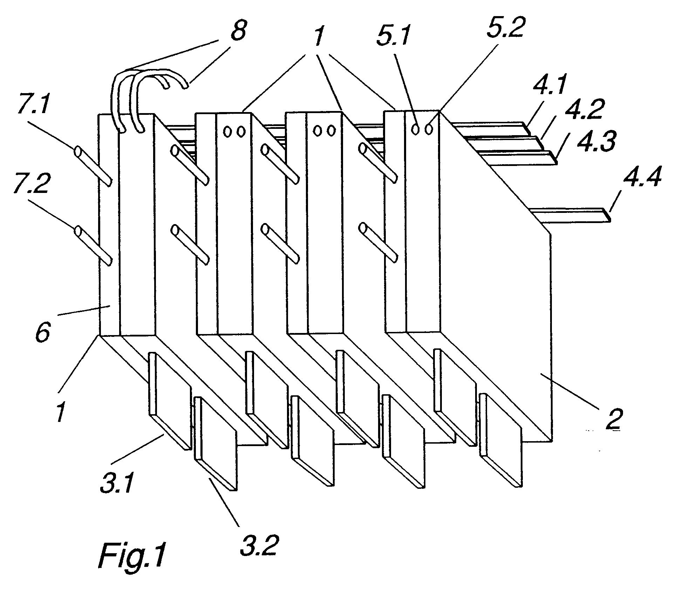

Die einzige Zeichnung (Figur 1) zeigt die Parallelschaltung von 4 erfindungsgemässen Leistungshalbleitermoduln.

### Wege zur Ausführung der Erfindung

Zunächst soll anhand der Figur 1 der Aufbau eines erfindungsgemässen Leistungshalbleitermoduls (1) erläutert werden. Es kann sich dabei um irgend ein Leistungshalbleitermodul handeln, z.B. um ein GTO-, Thyristor-, IGBT- oder Diodenmodul.

In jedem Fall umfasst das Modul (1) ein Gehäuse (2) mit z.B. zwei Hauptanschlüssen (3.1, 3.2), mindestens einen Steueranschluss (5.1, 5.2) und eine Anzahl Signalanschlüsse (4.1-4.4). Der Steueranschluss umfasst z.B. einen ersten Anschluss für vom Modul wegführende Signale und einen zweiten für hinführende Signale. Er ist insbesondere potentialfrei aufgebaut und kann z.B. über Lichtwellenleiter (8) mit einer nicht dargestellten Steuervorrichtung verbunden werden. Vorzugsweise werden die Leistungshalbleitermodule (1) auf einen Kühlkörper (6) montiert, der z.B. von einer Kühlflüssigkeit durchflossen wird. In diesem Fall sind am Kühlkörper (6) Kühlflüssigkeitsanschlüsse (7.1, 7.2) vorgesehen. Nach einer bevorzugten Aufbauvariante sind die Flüssigkeitsanschlüsse (7.1 und 7.2) und die Lichtwellenleiteranschlüsse (5.1 und 5.2) auf derselben Seite angeordnet.

Nach der Erfindung weist das Leistungshalbleitermodul (1) nun noch ein Anzahl - dargestellt sind 4 - Signalanschlüsse (4.1-4.4) auf. Die Signalanschlüsse können z.B.
- einen ersten Pfad für die Ansteuerung der Schalter,
- einen zweiten Pfad für Fehlermeldungen,
- einen dritten Pfad für die Taktung der Leistungshalbleitermodule, und
- einen vierten Pfad, über welchen die Steuerelektroden der Schalter verbindbar sind,

umfassen.

Bei der Parallelschaltung mehrerer erfindungsgemässer Module (1) entsteht damit ein Signal-Bus mit z.B. obigen Signalen. Vorzugsweise werden die Signalanschlüsse (4.1-4.4) auf einer separaten Seite des Gehäuses angeordnet.

In die Leistungshalbleitermodule (1) kann zudem ein Interface oder einen Schnittstelle integriert sein, welches die von der Steuervorrichtung kommenden und über die Lichtwellenleiter übertragenen Signale in die entsprechenden Signale für den Signal-Bus umwandelt. Die Signalanschlüsse (4.1-4.4) sind also mit den Steueranschlüssen (5.1, 5.2) signalmässig verbunden.

Besonders kostengünstig wird die Anordnung, wenn nur dasjenige Modul (1) mit einem Interface ausgerüstet ist, welches mit der Steuervorrichtung verbunden ist.

Bei der Parallelschaltung von mehreren erfindungsgemässen Leistungshalbleitermoduln (1) entsteht somit eine Schaltungsanordnung, bei welcher
- nur ein frei wählbares Leistungshalbleitermodul (1) über Steueranschlüsse (5.1, 5.2) mit einer Steuervorrichtung verbunden ist,
- eine Anzahl von Signalanschlüssen (4.1-4.4), welche signalmässig mit den Steueranschlüssen (5.1, 5.2) verbindbar sind, untereinander verbunden sind und einen Signal-Bus bilden.

Da nur ein Modul mit der Steuervorrichtung verbunden ist, arbeitet dieses als Master, dem die übrigen Module folgen. Auf diese Weise können die eingangs erwähnten Problem bei der Parallelschaltung von mehreren Moduln vermieden werden.

Insgesamt steht also mit der Erfindung ein Leistungshalbleitermodul zur Verfügung, welches problemlos bis zu höchsten Leistungen in einer Anordnung mit parallelgeschalteten Moduln eingesetzt werden kann.

### Bezeichnungsliste

- 1: Leistungshalbleitermodul
- 2: Gehäuse
- 3.1,3.2: Hauptanschlüsse
- 4.1-4.4: Signalanschlüsse
- 5.1,5.2: Steueranschlüsse, Lichtwellenleiteranschlüsse
- 6: Kühlkörper
- 7.1,7.2: Kühlflüssigkeitsanschlüsse
- 8: Lichtwellenleiter

## Patentansprüche

1. Schaltungsanordnung mit mindestens zwei Leistungshalbleiterschaltermoduln (1), welche je umfassen
a) ein Gehäuse (2), mindestens zwei Hauptanschlüsse (3.1, 3.2), und mindestens einen Steueranschluss (5.1, 5.2), welcher mit einer Steuervorrichtung verbindbar ist, wobei die Leistungshalbleitermodule (1) über die Steueranschlüsse (5.1, 5.2) angesteuert und überwacht werden können,
dadurch gekennzeichnet, dass
b) nur ein frei wählbares Leistungshalbleitermodul (1) über die Steueranschlüsse (5.1, 5.2) an die Steuervorrichtung angeschlossen ist,
c) eine Anzahl von Signalanschlüssen (4.1-4.4) vorgesehen sind, welche mit den Steueranschlüssen (5.1, 5.2) signalmässig verbindbar sind, und
d) die entsprechenden Signalanschlüsse (4.1-4.4) der Leistungshalbleitermodule (1) untereinander verbunden sind.

2. Schaltungsanordnung nach Anspruch 1, dadurch gekennzeichnet, dass die Steueranschlüsse (5.5, 5.2) einen ersten für zum Modul (1) hinführende Signale vorgesehen Anschluss (5.1) und einen zweiten (5.2) für vom Modul (1) wegführende Signale umfasst, welche Anschlüsse (5.1, 5.2) insbesondere als Lichtwellenleiteranschlüsse ausgeführt sind und über einen Lichtwellenleiter (8) mit der Steuervorrichtung verbindbar sind.

3. Schaltungsanordnung nach Anspruch 2, dadurch gekennzeichnet, dass die Hauptanschlüsse (3.1, 3.2) auf einer ersten Seite, die Signalanschlüsse (4.1-4.4) auf einer zweiten Seite und die Lichtwellenleiteranschlüsse (5.1, 5.2) auf einer dritten Seite des Gehäuses (2) angeordnet sind.

4. Schaltungsanordnung nach Anspruch 3, dadurch gekennzeichnet, dass
a) die Gehäuse (2) auf einen Kühlkörper (6) montiert sind,
b) eine Kühlflüssigkeit die Kühlkörper (6) durchströmt,
c) auf der dritten Seite des Gehäuses (1) Kühlflüssigkeitszu- und Abflüsse (7.1, 7.2) vorgesehen sind.

5. Schaltungsanordnung nach einem der Ansprüche 1-4, dadurch gekennzeichnet, dass die Signalanschlüsse (4.1-4.4) insbesondere umfassen:
- einen ersten Pfad für die Ansteuerung der Schalter der Leistungshalbleitermodule (1);
- einen zweiten Pfad für Fehlermeldungen der Leistungshalbleitermodule (1);
- einen dritten Pfad für die Taktung der Leistungshalbleitermodule (1); und
- einen vierten Pfad, über welchen alle Steuerelektroden der Schalter der Leistungshalbleitermodule (1) verbindbar sind.

6. Schaltungsanordnung nach einem der Ansprüche 1-5, dadurch gekennzeichnet, dass in jedem Modul (1) zwischen den Steueranschlüssen (5.1, 5.2) und den Signalanschlüssen (4.1-4.4) eine Schnittstelle vorgesehen ist.

7. Schaltungsanordnung nach einem der Ansprüche 1-5, dadurch gekennzeichnet, dass nur in dem mit der Steuervorrichtung verbundenen Modul (1) eine Schnittstelle zwischen den Steueranschlüssen (5.1,5.2) und den Signalanschlüssen (4.1, 4.2) vorgesehen ist.

8. Leistungshalbleitermodul (1) umfassend
a) ein Gehäuse (2), mindestens zwei Hauptanschlüsse (3.1, 3.2), und mindestens einen Steueranschluss (5.1, 5.2), welcher mit einer Steuervorrichtung verbindbar ist, wobei das Leistungshalbleitermodul (1) über den Steueranschluss angesteuert und überwacht werden kann,
dadurch gekennzeichnet, dass
b) eine Anzahl von Signalanschlüssen (4.1-4.4) vorgesehen ist, welche mit dem Steueranschluss (5.1 bzw. 5.2) signalmässig verbindbar sind.

9. Leistungshalbleitermodul nach Anspruch 8, dadurch gekennzeichnet, dass die Hauptanschlüsse (3.1, 3.2) auf einer ersten Seite, die Signalanschlüsse (4.1-4.4) auf einer zweiten Seite und die Steueranschlüsse (5.1, 5.2) auf einer dritten Seite des Gehäuses angeordnet sind.

10. Leistungshalbleitermodul nach Anspruch 9, dadurch gekennzeichnet, dass
a) die Gehäuse (2) auf einen Kühlkörper (6) montiert sind,
b) eine Kühlflüssigkeit die Kühlkörper (6) durchströmt,
c) auf der dritten Seite des Gehäuses Kühlflüssigkeitszu- und Abflüsse (7.1, 7.2) vorgesehen sind.

11. Leistungshalbleitermodul nach Anspruch 10, dadurch gekennzeichnet, dass die Signalanschlüsse (4.1-4.4) insbesondere umfassen:
- einen ersten Pfad für die Ansteuerung der Schalter der Leistungshalbleitermodule (1);
- einen zweiten Pfad für Fehlermeldungen der Leistungshalbleitermodule (1);
- einen dritten Pfad für die Taktung der Leistungshalbleitermodule (1); und
- einen vierten Pfad, über welchen alle Steuerelektroden der Schalter der Leistungshalbleitermodule (1) verbindbar sind.

12. Leistungshalbleitermodul nach Anspruch 11, dadurch gekennzeichnet, dass zwischen den Steueranschlüssen (5.1, 5.2) und den Signalanschlüssen (4.1-4.4) eine Schnittstelle vorgesehen ist.
